# EUROPÄISCHE PATENTSCHRIFT

(11) **EP 4 012 727 B1**
(45) Veröffentlichungstag und Bekanntmachung des Hinweises auf die Patenterteilung: **12.11.2025**
(21) Anmeldenummer: 21000320.8
(22) Anmeldetag: 11.11.2021
(51) Int. Cl.: H01C 1/14, H01C 1/16, H01C 17/28, H01C 17/22, H01C 7/06, H01C 1/146, H01C 1/144

(54) **MESSWIDERSTAND, WIDERSTANDSANORDNUNG UND VERFAHREN ZU DEREN HERSTELLUNG**
MEASURING RESISTOR, RESISTOR ASSEMBLY AND METHOD FOR THE PRODUCTION OF SAME
RÉSISTANCE DE MESURE, AGENCEMENT DE RÉSISTANCE ET SON PROCÉDÉ DE FABRICATION

(30) Priorität: 10.12.2020 DE 102020007556
(43) Veröffentlichungstag der Anmeldung: 15.06.2022
(73) Patentinhaber: Wieland-Werke AG, 89079 Ulm (DE)
(72) Erfinder: Voggeser, Volker, 89250 Senden (DE); Wolf, Michael, 89077 Ulm (DE); Kästle, Christoph, 89077 Ulm (DE); Noll, Tony Robert, 89165 Dietenheim (DE); Guther, Kim-Oliver, 89077 Ulm (DE); Walliser, Jochen, 89079 Ulm (DE); Schulz, Felix, 89077 Ulm (DE); Egle, Philipp-Morris, 89155 Erbach (DE); Thumm, Gerhard, 89155 Erbach (DE)

(56) Entgegenhaltungen:
- EP-A1- 3 674 716
- DE-A1- 10 204 669
- DE-B- 1 228 341
- DE-B1- 2 916 425
- KR-A- 20170 104 828
- US-A- 5 621 240

## Beschreibung

Die Erfindung betrifft eine Widerstandsanordnung zur Messung der Stromstärke sowie Verfahren zu Herstellung einer solchen Widerstandsanordnung.

Für die Strommessung in elektronischen Schaltungen werden Messwiderstände verwendet, die in Reihe zu dem zu überwachenden Bauteil geschaltet sind. Dabei wird die Stromstärke aus der über dem als Shunt-Widerstand bezeichneten Messwiderstand abfallenden Spannung bestimmt. Der Widerstandswert eines solchen niederohmigen Messwiderstands beträgt typischerweise 10 bis 50 µOhm. Die korrekte und verlässliche Messung der Stromstärke ist beispielsweise besonders wichtig in einem Batteriemanagementsystem eines Elektro- oder Hybridfahrzeugs.

Eine Widerstandsanordnung zur Messung der Stromstärke umfasst mindestens zwei Anschlusselemente, die zum Verbinden der Widerstandsanordnung mit einem äußeren Stromkreis dienen, sowie mindestens ein Widerstandselement, das bezogen auf die Stromflussrichtung zwischen den Anschlusselementen angeordnet ist. Eine solche Widerstandsanordnung kann aus einem längsnahtgeschweißten Verbundmaterial hergestellt werden. Dies ist beispielsweise aus der Druckschrift EP 0 605 800 A1 bekannt. Das Verbundmaterial wird aus drei Metallbändern hergestellt, indem die einzelnen Metallbänder jeweils über eine Längsnaht miteinander durch ein Elektronenstrahl- oder Laserschweißverfahren verbunden werden.

Das Material des Widerstandselements weist einen höheren spezifischen Widerstand als das Material der Anschlusselemente auf. Ferner ist der spezifische Widerstand des Materials des Widerstandselements kaum von der Temperatur abhängig, während der spezifische Widerstand des Materials der Anschlusselemente eine signifikante Temperaturabhängigkeit aufweist.

Üblicherweise wird die über dem Messwiderstand abfallende Spannung mittels Messabgriffen erfasst, die beidseitig vom Widerstandselement an oder auf den Anschlusselementen angebracht sind. Dies hat den Vorteil, dass die Größe des Widerstandswerts überwiegend durch die leicht kontrollierbare Geometrie des Widerstandselements bestimmt wird und nur in deutlich geringerem Maße von der Position der Messabgriffe auf den gut leitenden Anschlusselementen. Die Temperaturabhängigkeit des Widerstands des Materials der Anschlusselemente hat bei dieser Methode jedoch einen nicht zu vernachlässigenden Einfluss auf das Messsignal. Um diesen Einfluss zu vermeiden, wird beispielsweise in den Druckschriften EP 2 446 449 B1 und WO 2011/ 028 870 A1 vorgeschlagen, durch geeignete Einschnitte oder Schlitze in den Anschlusselementen die Krümmung der Äquipotenziallinien so zu verändern, dass der Temperatureinfluss auf das Messsignal minimiert wird.

Der Temperatureinfluss der Anschlusselemente auf das Messsignal kann ganz eliminiert werden, indem die Spannung direkt am Widerstandselement abgegriffen wird. Hierfür müssen die Spannungsabgriffe jedoch sehr genau auf dem Widerstandselement positioniert werden, um den vorgegebenen Widerstandswert einzuhalten und somit die gewünschte Messgenauigkeit zu erreichen. Ferner ist es in manchen Anwendungen notwendig, zusätzlich zu der über dem gesamten Messwiderstand abfallenden Spannung auch die Spannung zu erfassen, die über einem Teil des Messwiderstands abfällt. Hierfür muss mindestens ein Spannungsabgriff sehr genau an einer vorbestimmten Stelle auf dem Widerstandselement positioniert werden, um die erforderliche Messgenauigkeit zu erreichen.

Das Dokument DE 29 16 425 B1 offenbart einen Dehnungsmessstreifen, bei dem eine Widerstandsschicht auf einem dünnen Träger aufgebracht und mit Anschlusselementen versehen ist. Quer über die Widerstandsschicht ist zumindest ein Streifen einer Kontaktschicht gelegt.

Das Dokument US 5 621 240 A offenbart eine Widerstandanordnung mit einem Widerstandselement und Anschlusselementen. Das Widerstandselement besteht aus einem Widerstandsteil, der durch drei Leiterstäbe unterteilt ist. Der Widerstandsteil besteht aus einer Widerstandszusammensetzung, während die Leiterstäbe aus einer elektrisch leitenden Zusammensetzung bestehen.

Das Dokument DE 1 228 341 B offenbart ein Halbleiterbauelement, bestehend aus einem Siliciumstab mit Elektroden an seinen beiden Enden. Mit dem Siliciumstab ist ein Aluminiumdraht durch Ultraschall-Schweißung verbunden.

Das Dokument DE 102 04 669 A1 offenbart eine Widerstandsanordnung mit Rücksprüngen im Material des Widerstandselements. Die Rücksprünge werden gebildet, indem Leitermaterial durch Druck in das ursprünglich planare Material des Widerstandselements gepresst wird. Folglich sind die Rücksprünge im Material des Widerstandselements mit Leitermaterial aufgefüllt, so dass die Widerstandsanordnung nach Außen eine vollkommen ebene Oberfläche aufweist.

Das Dokument EP 3 674 716 A1 offenbart einen Shunt-Widerstand mit zwei Sammelschienen aus elektrisch leitendem Material und zwei Verbindungselementen, die ebenfalls aus elektrisch leitendem Material sind. Die Verbindungselemente sind so gestaltet, dass mittels Vergrößern oder Verkleinern ihrer Kontaktfläche der Widerstandswert des Shunt-Widerstands eingestellt werden kann.

Das Dokument KR 1020170104828 A offenbart einen Shunt-Widerstand mit Anschlusselementen und einem zwischen den Anschlusselementen angeordneten Widerstandselement. An den Anschlusselementen sind Spannungsabgriffe angebracht, die eine Leiterplatte kontaktieren. Ferner ist eine Schutzstruktur aus Harz offenbart, die erhabene Elemente als Abstandshalter aufweisen kann.

Der Erfindung liegt somit die Aufgabe zugrunde, eine Widerstandsanordnung mit verbesserter Messgenauigkeit sowie Verfahren zu deren Herstellung anzugeben. Ferner soll die Widerstandsanordnung wirtschaftlich herstellbar sein.

Die Erfindung wird bezüglich einer ersten Widerstandsanordnung durch die Merkmale des Anspruchs 1, bezüglich einer zweiten Widerstandsordnung durch die Merkmale des Anspruchs 5, bezüglich eines ersten Verfahrens durch die Merkmale des Anspruchs 8 und bezüglich eines zweiten, alternativen Verfahrens durch die Merkmale des Anspruchs 9 wiedergegeben. Die weiteren rückbezogenen Ansprüche betreffen vorteilhafte Aus-'und Weiterbildungen der Erfindung.

Die Erfindung schließt eine Widerstandsanordnung zur Messung der Stromstärke ein, die mindestens zwei Anschlusselemente und mindestens ein zwischen den Anschlusselementen angeordnetes Widerstandselement mit einem streifen- oder plattenförmigen Grundkörper umfasst. Das Widerstandselement weist eine Oberseite, eine zur Oberseite parallele Unterseite und zwei parallel zueinander verlaufende Längsseiten auf. Der Abstand zwischen Oberseite und Unterseite definiert die Dicke D des Widerstandselements. Der Abstand der beiden Längsseiten zueinander definiert die Breite B des Widerstandselements. Die Erstreckung des Widerstandselements in Richtung der Längsseiten und senkrecht zu seiner Dicke definiert die Länge L des Widerstandselements. In vielen Fällen ist das Widerstandselement so dimensioniert, dass L > B > D ist. Das mindestens eine Widerstandselement besteht aus einem Material, dessen elektrische Leitfähigkeit geringer als die elektrische Leitfähigkeit des Materials der Anschlusselemente ist. Das Widerstandselement weist auf seiner Oberseite oder auf seiner Unterseite oder sowohl auf seiner Oberseite als auch auf seiner Unterseite mindestens ein Formelement als Positionierhilfe für das Anbringen eines elektrischen Leiters als Messabgriff auf.

Die vorstehend beschriebene Widerstandsanordnung kann einen niederohmigen

Shunt-Widerstand als Widerstandselement umfassen. Die Anschlusselemente der Widerstandsanordnung können aus Kupfer, einer bevorzugt niedriglegierten Kupferlegierung, aus Aluminium oder einer bevorzugt niedriglegierten Aluminiumlegierung sein oder mindestens einen dieser Werkstoffe umfassen. Das Widerstandselement kann aus einer Kupferlegierung bestehen, die als Widerstandslegierung üblicherweise verwendet wird. Der spezifische elektrische Widerstand des Materials des Widerstandselements ist mindestens um einen Faktor 10 größer als der spezifische elektrische Widerstand des Materials der Anschlusselemente. Ferner weist das Material des Widerstandselements einen spezifischen elektrischen Widerstand auf, der sich wesentlich weniger mit der Temperatur verändert als der spezifische Widerstand des Materials der Anschlusselemente. Der Widerstandstemperaturkoeffizient des Materials der Anschlusselemente ist sehr viel größer, typischerweise mindestens um einen Faktor 80 größer als der Betrag des Widerstandstemperaturkoeffizienten des Materials des Widerstandselements. Üblicherweise beträgt der Betrag des Widerstandstemperaturkoeffizienten des Materials des Widerstandselements weniger als 5·10⁻⁵ 1/K, während der Widerstandstemperaturkoeffizient des Materials der Anschlusselemente ungefähr 4·10⁻³ 1/K beträgt.

Die Anschlusselemente der Widerstandsanordnung dienen zur Einbindung der Widerstandsanordnung in einen äußeren Stromkreis. Hierzu können die Anschlusselemente jeweils mindestens ein Verbindungsmittel aufweisen. Ein solches Verbindungsmittel kann beispielsweise eine Bohrung mit oder ohne Innengewinde oder ein eingepresster Bolzen sein. Das Widerstandselement kann an seinen Längsseiten mit jeweils einem Anschlusselement elektrisch leitend verbunden, bevorzugt verschweißt sein. Die Anschlusselemente können endständige Anschlusselemente der Widerstandsanordnung sein. Es ist aber auch möglich, dass mindestens ein Anschlusselement in Bezug auf einen möglichen Strompfad zwischen zwei Widerstandselementen angeordnet ist. Durch die Positionierung der Anschlusselemente und des Widerstandselements zueinander wird im Widerstandselement eine Stromflussrichtung definiert, die im Wesentlichen senkrecht zu den Längsseiten des Widerstandselements ist.

Die Widerstandsanordnung kann in planarer Anordnung ausgebildet sein. Dabei sind die Anschlusselemente und das mindestens eine Widerstandselement als platten- oder streifenförmige Elemente gebildet und in einer Ebene nebeneinander, bevorzugt in einer Reihe, angeordnet. Die Dicke D eines Widerstandselements kann dabei im Verhältnis zur Dicke der Anschlusselemente beliebig sein. Üblicherweise ist sie aber nicht größer als die Dicke der Anschlusselemente.

Unter einem Formelement wird im Rahmen dieser Erfindung jede gezielte Formänderung verstanden, die eine Abweichung von der geometrisch ebenen Oberfläche darstellt und die geeignet ist, zumindest in einer Raumrichtung eine bestimmte Position auf der Ober- oder Unterseite des Widerstandselements festzulegen. Die Erstreckung der Formänderung ist dabei zumindest in Richtung längs zur Stromflussrichtung lokal begrenzt, um bezüglich dieser Richtung eine Position zu definieren. Das Formelement bestimmt somit zumindest einen Bereich, der sich quer zur Stromflussrichtung erstreckt. Das Formelement kann auch einen nahezu punktförmigen Ort bestimmen. Ein Formelement kann beispielsweise eine Vertiefung in der Oberseite oder in der Unterseite des Widerstandselements oder eine Erhebung über die sonst ebene Oberfläche der Oberseite oder Unterseite des Widerstandselements sein. Im Fall einer Erhebung ist das Material der Erhebung bevorzugt monolithisch mit dem Material des Widerstandselements verbunden.

Das Formelement ist eine Positionierhilfe bei der Kontaktierung eines elektrischen Leiters, insbesondere bei der Positionierung des Endes eines elektrischen Leiters. Der elektrische Leiter kann beispielsweise ein Draht, ein metallischer Stift oder ein Pin sein. Im Fall eines erhabenen Formelements kann der Leiter auch eine Leiterbahn einer Platine sein. Der elektrische Leiter oder das Ende des elektrischen Leiters kann mit dem Widerstandselement bevorzugt stoffschlüssig verbunden werden, beispielsweise durch Schweißen oder Löten. Der elektrische Leiter dient als Messabgriff zur Bestimmung der über zumindest einem Teil des Widerstandselements abfallenden elektrischen Spannung.

Der besondere Vorteil der vorstehend beschriebenen Widerstandsanordnung besteht darin, dass das Formelement als Positionierhilfe für das Anbringen eines Messabgriffs verwendet werden kann. Das Formelement kann bereits während der Herstellung der Widerstandsanordnung mit sehr hoher örtlicher Genauigkeit in das Widerstandselement eingebracht werden. Diese hohe örtliche Genauigkeit wird auf die Position des Messabgriffs übertragen, so dass dessen Position auf dem Widerstandselement auch sehr genau vorherbestimmt ist. Weil die Position des Messabgriffs die Größe des zur Spannungsmessung dienenden Widerstands bestimmt, kann auf diese Weise auch die Größe dieses Widerstands sehr genau vorherbestimmt werden.

Das Formelement kann beispielsweise auch als Positionierhilfe für ein optisch gestütztes Positioniersystem dienen. Hierbei erfasst ein optischer Sensor, beispielsweise eine Kamera, die Position des Formelements auf dem Widerstandselement. Die Position des Formelements dient dann als Referenz für die Anbringung des Messabgriffs auf der Oberfläche des Widerstandselements.

Ferner kann das Formelement auch zur Kontaktierung des elektrischen Leiters dienen. In diesem Fall kontaktiert der elektrische Leiter das Widerstandselement über das Formelement.

Das mindestens eine Formelement kann bei der Herstellung des Bands, aus dem das Widerstandselement gebildet wird, beispielsweise durch einen Ziehvorgang oder einen Walzvorgang, eingebracht werden. Bevorzugt erfolgt das Einbringen des Formelements in das Band nach dem Bearbeitungsschritt, in dem die Breite des Bands festgelegt wird. Dadurch wird eine hohe Genauigkeit der Position des Formelements auf dem Widerstandselement erreicht. Alternativ ist es aber auch möglich, zuerst das Formelement in das Band einzubringen und danach die finale Breite des Bands festzulegen. Das Formelement dient in diesem Fall als Referenz, anhand derer der jeweilige Abstand der Längsseiten des Bands zum Formelement bestimmt werden kann.

Bevorzugt kann sich das Formelement parallel zu den Längsseiten des Widerstandselements und über dessen gesamte Länge L erstrecken. Ein solches Formelement kann bei der Herstellung des Bands, aus dem das Widerstandselement gebildet wird, besonders einfach eingebracht werden, beispielsweise durch einen Ziehvorgang.

Bevorzugt weist das Widerstandselement mindestens zwei Formelemente auf. Mittels Messabgriffen, die mit Hilfe dieser Formelemente auf dem Widerstandselement positioniert werden, kann die Spannung abgegriffen werden, die entlang des Strompfads zwischen diesen beiden Kontaktstellen abfällt. Weil die Messabgriffe auf dem Widerstandselement und nicht auf den Anschlusselementen positioniert sind, entfällt der durch das Material der Anschlusselemente verursachte Temperatureinfluss auf den Widerstandswert vollständig. Der Widerstandswert bleibt auch bei sich verändernder Temperatur nahezu konstant. Besonders bevorzugt sind die Formelemente jeweils nahe an den beiden Längsseiten des Widerstandselements positioniert. In diesem Fall wird durch die Messabgriffe nahezu die gesamte über dem Widerstandselement abfallende Spannung erfasst. Das gemessene Signal ist dann maximal, wodurch relative Messunsicherheiten minimiert werden.

Der spezifische elektrische Widerstand des Materials des Widerstandselements kann von Charge zu Charge variieren. Bei aus dem Stand der Technik bekannten Widerstandsanordnungen, bei denen die Spannungsabgriffe auf den Anschlusselementen positioniert sind, wird diese Variation kompensiert, indem das Widerstandselement in einem nachfolgenden Bearbeitungsschritt getrimmt wird, also seine Länge L angepasst wird. Bei einer erfindungsgemäßen Widerstandsanordnung kann die Variation des spezifischen Widerstands auch ohne dieses Trimmen kompensiert werden, indem der Abstand der Messabgriffe auf dem Widerstandselement entsprechend angepasst wird. Hierzu wird die Position mindestens eines Formelements auf dem Widerstandselement in Bezug zur Stromflussrichtung gezielt verändert, so dass ein Messwiderstand mit einem bestimmten, vorgegebenen Widerstandswert erzeugt wird. Je kleiner der relativ zur Stromflussrichtung gemessene Abstand zwischen zwei Messabgriffen ist, desto kleiner ist der Widerstand im Widerstandselement zwischen den Messabgriffen. Auf diese Weise können bei gleicher Breite und Dicke des Widerstandselements auch Messwiderstände mit unterschiedlichen Widerstandswerten hergestellt werden.

In einer besonderen Ausführungsform weist das Widerstandselement mindestens drei Formelemente auf. Es können dann drei oder mehr Messabgriffe auf dem Widerstandselement sehr genau positioniert werden. An einem solchen Widerstandselement können dann redundante Spannungsmessungen durchgeführt werden, wodurch die Sicherheit und Verlässlichkeit der Messung erhöht werden.

Gemäß eines ersten Aspekts der Erfindung ist das mindestens eine Formelement eine Aussparung im Material des Widerstandselements zur Aufnahme eines Endes eines elektrischen Leiters. Insbesondere kann die Aussparung eine Vertiefung im Material des Widerstandselements sein, wobei sich die Vertiefung nur über einen Teil der Dicke D des Widerstandselements erstreckt. Beispiele hierfür sind eine Blindbohrung, eine Kerbe, ein Grübchen (dimple), eine Lochung (punching) oder eine Nut. Solche Vertiefungen können beispielsweise mittels Prägen oder mittels Zerspanung eingebracht werden. In einer Aussparung kann das Ende eines elektrischen Leiters besonders gut aufgenommen werden, so dass eine genaue Positionierung des Leiters besonders leicht und sicher erfolgen kann.

Im Rahmen einer speziellen Ausgestaltung dieser Ausführungsform kann die Aussparung eine Nut sein, die sich parallel zu den Längsseiten des Widerstandselements und bevorzugt über dessen gesamte Ausdehnung in Längsrichtung, also über dessen gesamte Länge L erstreckt. Eine solche Nut kann bei der Herstellung des Bands, aus dem das Widerstandselement gebildet wird, besonders einfach, beispielsweise durch einen Ziehprozess oder Walzprozess, hergestellt werden.

Im Rahmen einer besonders vorteilhaften Ausgestaltung dieser Ausführungsform kann die Nut einen V-förmigen Querschnitt aufweisen. In einer V-förmigen Nut kann sich das Ende des Leiters selbst zentrieren, so dass eine hohe Genauigkeit der Position sicher erreicht wird.

Im Rahmen einer weiteren Ausgestaltung dieser Ausführungsform kann die Aussparung zumindest teilweise mit Lot gefüllt sein. Dadurch ist es möglich, dass das Ende des elektrischen Leiters an einer genau definierten Position auf dem Widerstandselement angelötet wird.

Gemäß eines zweiten Aspekts der Erfindung weist das mindestens eine Formelement einen Bereich auf, der über die Oberseite oder über die Unterseite des Widerstandselements erhaben ist, wobei das Material des erhabenen Bereichs monolithisch mit dem Material des Widerstandselements verbunden ist. Bevorzugt kann das Formelement in diesem Bereich zumindest teilweise mit Lot beschichtet sein. Insbesondere kann dabei der Bereich des Formelements, der am weitesten von der Oberseite oder der Unterseite des Widerstandselements entfernt ist, mit Lot beschichtet sein. Dieser Bereich kann beispielsweise die Fläche des Widerstandselements sein, die am weitesten von der Ober- oder Unterseite des Widerstandselements entfernt ist. Bei dieser Ausführungsform kann beispielsweise eine Leiterbahn einer Platine ohne zusätzlichen Aufwand an das Formelement angelötet werden.

In weiterer vorteilhafter Ausgestaltung der Erfindung kann ein Formelement mittig zwischen den Längsseiten des Widerstandselements angeordnet sein. Dies ermöglicht die genaue Positionierung eines Messabgriffs in der Mitte des Widerstandselements. Mit einem solchen mittig positionierten Messabgriff kann die Spannung über dem halben Widerstandselement abgegriffen werden. Zusammen mit einer Spannungsmessung über dem gesamten Widerstandselement werden zwei beziehungsweise sogar drei redundante Messsignale bereitgestellt, aus deren Vergleich sich die Verlässlichkeit der Messung beurteilen lässt.

Hinsichtlich weiterer technischer Merkmale und Vorteile der Widerstandsanordnung wird hiermit explizit auf die Erläuterungen im Zusammenhang mit den nachstehend beschriebenen Verfahren zur Herstellung einer Widerstandsanordnung sowie auf die Figuren, die Figurenbeschreibung und die Ausführungsbeispiele verwiesen.

Ein weiterer Aspekt der Erfindung schließt ein Verfahren zur Herstellung einer vorstehend beschriebenen Widerstandsanordnung ein, wobei das Verfahren folgende Schritte umfasst:
a) Bereitstellen eines ersten Bands aus einem ersten Material, wobei das Band eine Oberseite und eine Unterseite sowie zwei zueinander parallele Längsseiten aufweist,
b) Festlegen der zwischen den beiden Längsseiten gemessenen Breite B des ersten Bands durch Bearbeitung der Längsseiten,
c) Einbringen mindestens eines Formelements in mindestens die Oberseite oder mindestens die Unterseite des ersten Bands,
d) Längsnahtschweißen des ersten Bands an seinen beiden Längsseiten mit jeweils einem weiteren Band aus einem Material, dessen elektrische Leitfähigkeit größer als die elektrische Leitfähigkeit des ersten Materials ist, wobei ein bandförmiger Werkstoffverbund gebildet wird,
e) Zertrennen des in Schritt d) gebildeten bandförmigen Werkstoffverbunds zur Herstellung einer Widerstandsanordnung, wobei aus dem Material des ersten Bands ein Widerstandselement der Widerstandsanordnung gebildet wird.

Hinsichtlich der zur Beschreibung des Verfahrens verwendeten Begriffe wird hiermit explizit auf die vorstehenden Erläuterungen der Begriffe im Zusammenhang mit der Beschreibung der Widerstandsanordnung verwiesen.

Das erste Band besteht aus einem Material mit einer elektrischen Leitfähigkeit, die kaum von der Temperatur abhängt. Die weiteren Bänder, die mit dem ersten Band verschweißt werden, bestehen jeweils aus einem Material, dessen elektrische Leitfähigkeit eine signifikante Abhängigkeit von der Temperatur aufweist. Aus dem Material der beiden weiteren Bänder können Anschlusselemente der Widerstandsanordnung gebildet werden.

Im Verfahrensschritt b) wird die Breite B des ersten Bands festgelegt. Dies kann durch Besäumen, beispielsweise durch Fräsen, der Längsseiten des Bands erfolgen. Nachdem die Breite des ersten Bands fixiert ist, wird in Verfahrensschritt c) mindestens ein Formelement in die Oberseite oder in die Unterseite oder sowohl in die Oberseite als auch in die Unterseite des Bands eingebracht. Das Formelement kann beispielsweise durch einen Prägeschritt, durch Zerspanen oder bevorzugt durch einen Zieh- oder Walzvorgang eingebracht werden.

Der besondere Vorteil des Verfahrens besteht darin, dass das Einbringen des mindestens einen Formelements in die Ober- und/oder Unterseite des ersten Bands erst nach dem Festlegen der Breite B des Bands erfolgt. Somit kann das Formelement sehr genau in Bezug auf die durch die Längsseiten definierten Ränder des Bands positioniert werden. Entsprechend genau kann in einem späteren Bearbeitungsschritt das Ende eines elektrischen Leiters mit Hilfe des Formelements auf dem Widerstandselement positioniert werden.

Die Verfahrensschritte c) und d) können auch in umgekehrter Reihenfolge durchgeführt werden.

Das Zertrennen in Schritt e) erfolgt bevorzugt quer zur Längsrichtung des bandförmigen Werkstoffverbunds, also insbesondere quer zur Längsrichtung des ersten Bands.

Ein weiterer Aspekt der Erfindung schließt ein alternatives Verfahren zur Herstellung einer vorstehend beschriebenen Widerstandsanordnung ein, wobei das Verfahren folgende Schritte umfasst:
a) Bereitstellen eines ersten Bands aus einem ersten Material, wobei das Band eine Oberseite und eine Unterseite sowie zwei Längsseiten aufweist, und wobei das erste Band auf mindestens seiner Oberseite oder mindestens seiner Unterseite mindestens ein Formelement aufweist,
b) Festlegen der zwischen den beiden Längsseiten gemessenen Breite B des ersten Bands durch Bearbeitung der Längsseiten,
c) Längsnahtschweißen des ersten Bands an seinen beiden Längsseiten mit jeweils einem weiteren Band aus einem Material, dessen elektrische Leitfähigkeit größer als die elektrische Leitfähigkeit des ersten Materials ist, wobei ein bandförmiger Werkstoffverbund gebildet wird,
d) Zertrennen des in Schritt c) gebildeten bandförmigen Werkstoffverbunds zur Herstellung einer Widerstandsanordnung, wobei aus dem Material des ersten Bands ein Widerstandselement der Widerstandsanordnung gebildet wird.

Hinsichtlich der zur Beschreibung des alternativen Verfahrens verwendeten Begriffe wird hiermit explizit auf die vorstehenden Erläuterungen der Begriffe im Zusammenhang mit der Beschreibung der Widerstandsanordnung verwiesen.

Das erste Band besteht aus einem Material mit einer elektrischen Leitfähigkeit, die kaum von der Temperatur abhängt. Die weiteren Bänder, die mit dem ersten Band verschweißt werden, bestehen jeweils aus einem Material, dessen elektrische Leitfähigkeit eine signifikante Abhängigkeit von der Temperatur aufweist. Aus dem Material der beiden weiteren Bänder können Anschlusselemente der Widerstandsanordnung gebildet werden.

Das erste Band weist auf seiner Oberseite oder seiner Unterseite oder sowohl auf seiner Oberseite als auch auf seiner Unterseite mindestens ein Formelement auf.

Das Formelement kann sich kontinuierlich entlang der gesamten Länge des Bands erstrecken. Dabei kann das Formelement beispielsweise eine Vertiefung in Form einer Längsnut oder eine Erhebung in Form einer Längsrippe sein. Formelemente, die sich kontinuierlich entlang der gesamten Länge des Bands erstrecken, können besonders vorteilhaft bereits bei der Herstellung des Bands erzeugt werden. Dies kann insbesondere mittels eines Ziehprozesses oder eines Walzprozesses erfolgen, bei dem ein entsprechendes Werkzeug zur Formgebung verwendet wird. Durch das Zertrennen des bandförmigen Werkstoffs in Schritt d) werden Widerstandsanordnungen mit jeweils einem Widerstandselement gebildet. Die Widerstandselemente weisen ein Formelement auf, das sich über die gesamte Länge eines Widerstandselements erstreckt.

Alternativ kann das mindestens eine Formelement als in Längsrichtung des Bands begrenztes Formelement gebildet sein. Dabei kann das Formelement beispielsweise eine lokale Aussparung in Form einer kegelförmigen Vertiefung oder eine lokale Erhebung in Form eines Zylinders oder eines Kegelstumpfs sein. Das erste Band weist dann eine Vielzahl solcher Formelemente auf, die entlang einer Reihe in einem sich wiederholenden Abstand über die gesamte Länge des Bands angeordnet sind. Solche Formelemente können beispielsweise durch einen Prägevorgang in das Band eingebracht werden. Bei Formelemente, deren Erstreckung in Längsrichtung des Bands begrenzt ist, erfolgt das Zertrennen des bandförmigen Werkstoffverbunds in Schritt d) so, dass das Widerstandselement jeder Widerstandsanordnung mindestens ein Formelement aufweist.

Im Verfahrensschritt b) wird die Breite B des ersten Bands festgelegt. Dies kann durch Besäumen, beispielsweise durch Fräsen, der Längsseiten des Bands erfolgen. Der besondere Vorteil des Verfahrens besteht darin, dass die Position des Formelements auf dem ersten Band sehr präzise mittels geeigneter Sensoren erfasst werden kann. Dies ermöglicht, die Breite des ersten Bands so festzulegen, dass das Formelement eine bestimmte Position in Bezug auf die Breite des ersten Bands aufweist. Insbesondere kann das Band so besäumt werden, dass das Formelement nach Schritt b) genau mittig zwischen den Längsseiten des ersten Bands positioniert ist.

Das Zertrennen in Schritt d) erfolgt bevorzugt quer zur Längsrichtung des bandförmigen Werkstoffverbunds, also insbesondere quer zur Längsrichtung des ersten Bands.

Hinsichtlich weiterer technischer Merkmale und Vorteile der beiden vorstehend beschriebenen Verfahren wird hiermit explizit auf die Erläuterungen im Zusammenhang mit der erfindungsgemäßen Widerstandsanordnung sowie auf die Figuren, die Figurenbeschreibung und die Ausführungsbeispiele verwiesen. Insbesondere wird bezüglich der Form, der Lage und der Anzahl der Formelemente auf die dort beschriebenen Ausführungsformen verwiesen. Ausführungsbeispiele der Erfindung werden anhand der schematischen Zeichnungen näher erläutert.

Darin zeigen:
Fig. 1 eine Schrägansicht einer Widerstandsanordnung mit einem Formelement
Fig. 2 eine Seitenansicht der Widerstandsanordnung gemäß Fig. 1
Fig. 3 eine Schrägansicht einer Widerstandsanordnung mit einem alternativen Formelement
Fig. 4 eine Seitenansicht der Widerstandsanordnung gemäß Fig. 3
Fig. 5 eine Schrägansicht einer Widerstandsanordnung mit einer Nut
Fig. 6 eine Seitenansicht der Widerstandsanordnung gemäß Fig. 5
Fig. 7 eine Seitenansicht einer Widerstandsanordnung mit zwei Formelementen
Fig. 8 eine Seitenansicht einer Widerstandsanordnung mit drei Formelementen
Fig. 9 eine Seitenansicht einer Widerstandsanordnung mit einer lotgefüllten Nut

Einander entsprechende Teile sind in allen Figuren mit denselben Bezugszeichen versehen.

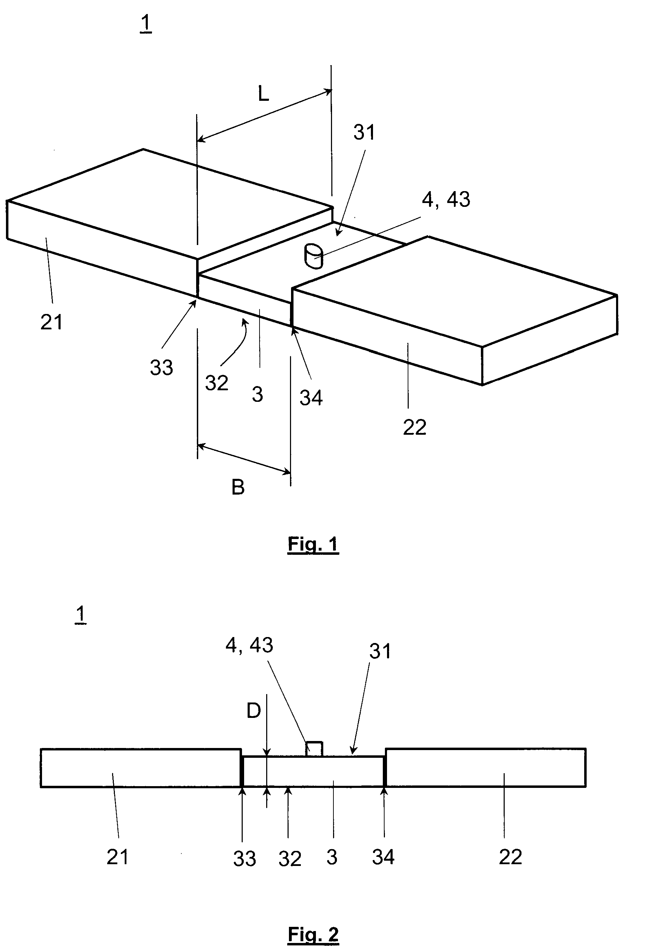

Fig. 1 zeigt eine Schrägansicht einer Widerstandsanordnung 1 mit einem Formelement 4. Fig. 2 zeigt eine Seitenansicht der Widerstandsanordnung gemäß Fig. 1. Die Widerstandsanordnung 1 umfasst zwei Anschlusselemente 21, 22. Zwischen den Anschlusselementen 21, 22 ist ein Widerstandselement 3 angeordnet, das einen Grundkörper in Form eines Streifens oder einer Platte hat.

Das Widerstandselement 3 weist eine im Wesentlichen ebene Oberseite 31 und eine der Oberseite gegenüber liegende, im Wesentlichen ebene Unterseite 32 auf. Es weist eine Dicke D, eine Länge L und eine Breite B auf. Diese Maße sind wie in den Figuren dargestellt definiert. Das Widerstandselement 3 ist an seinen beiden Längsseiten 33, 34 jeweils mit einem Anschlusselement 21, 22 elektrisch leitend verbunden. Dadurch wird im Widerstandselement 3 eine Stromflussrichtung definiert, die senkrecht zu den beiden Längsseiten 33, 34, also längs zur Breitenrichtung, orientiert ist. Die Anschlusselemente 21, 22 können Verbindungsmittel zum Einbinden der Widerstandsanordnung 1 in einen äußeren Stromkreis aufweisen. Diese Verbindungsmittel sind aus Gründen der Übersichtlichkeit nicht dargestellt.

Auf seiner Oberseite 31 weist das Widerstandselement 3 ein mittig angeordnetes Formelement 4 auf, das als lokale, zylinderförmige Erhebung 43 gebildet ist. Alternativ kann die Erhebung 43 auch als Kegel oder Kegelstumpf gebildet sein. Die Erhebung 43 ist sowohl in Stromflussrichtung als auch quer zur Stromflussrichtung begrenzt. Die Größe des Formelements 4 ist innerhalb der Widerstandsanordnung 1 nicht maßstabsgetreu dargestellt. Durch das Formelement 4, 43 wird auf der Oberseite 31 des Widerstandselements 3 eine Position definiert, an der das Ende eines nicht dargestellten elektrischen Leiters angebracht werden kann. Bevorzugt ist die Höhe der Erhebung 43 so gewählt, dass die Erhebung 43 einen Bereich aufweist, der über die beiden Anschlusselemente 21, 22 hinausragt. Dies erleichtert beispielsweise die Kontaktierung einer Leiterbahn einer Leiterplatte. Die vom Widerstandselement 3 abgewandte Fläche des Formelements 4, 43 kann mit Lot beschichtet sein. Damit wird das spätere Anlöten einer Leiterbahn vereinfacht.

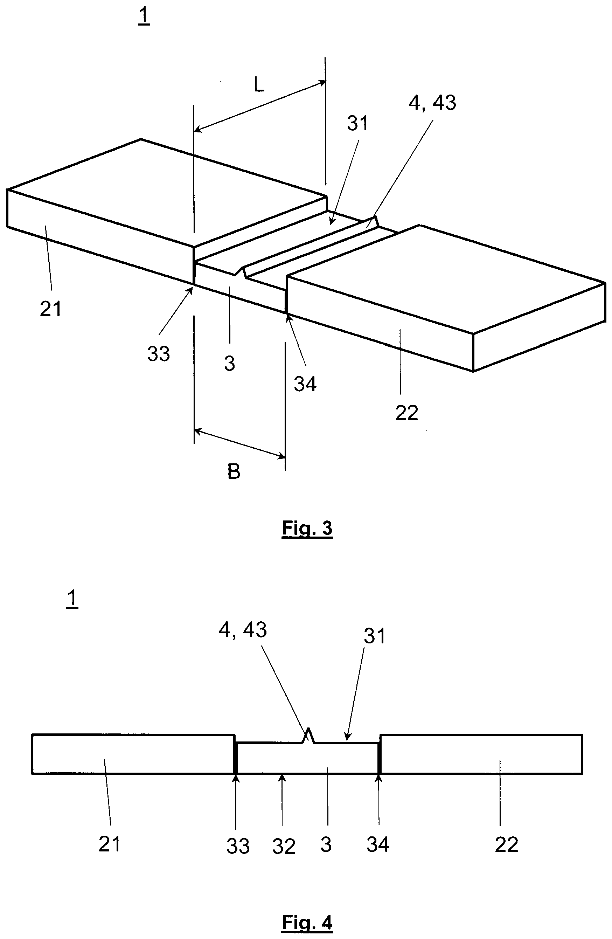

Fig. 3 zeigt eine Schrägansicht einer Widerstandsanordnung 1 mit einem alternativen Formelement 4. Fig. 4 zeigt eine Seitenansicht der Widerstandsanordnung gemäß Fig. 3. Das Widerstandselement 3 ist an seinen beiden Längsseiten 33, 34 jeweils mit einem Anschlusselement 21, 22 elektrisch leitend verbunden. Dadurch wird im Widerstandselement 3 eine Stromflussrichtung definiert, die senkrecht zu den beiden Längsseiten 33, 34, also längs zur Breitenrichtung, orientiert ist. Die Anschlusselemente 21, 22 können Verbindungsmittel zum Einbinden der Widerstandsanordnung 1 in einen äußeren Stromkreis aufweisen. Diese Verbindungsmittel sind aus Gründen der Übersichtlichkeit nicht dargestellt.

Auf seiner Oberseite 31 weist das Widerstandselement 3 ein Formelement 4 auf, das als Erhebung 43 gebildet ist. Die Erhebung 43 erstreckt sich in Form eines Dreikantprofils oder eines Grats parallel zu den beiden Längsseiten 33, 34 über die gesamte Länge L des Widerstandselements 3. Die Erhebung 43 ist also in Stromflussrichtung räumlich begrenzt, nicht jedoch quer zur Stromflussrichtung. Durch seine räumliche Begrenzung in Stromflussrichtung definiert das Formelement 4, 43 einen Bereich, der als Positionierhilfe für das Ende eines elektrischen Leiters dient. Bevorzugt ist die Höhe der Erhebung 43 so gewählt, dass die Erhebung 43 einen Bereich aufweist, der über die beiden Anschlusselemente 21, 22 hinausragt.

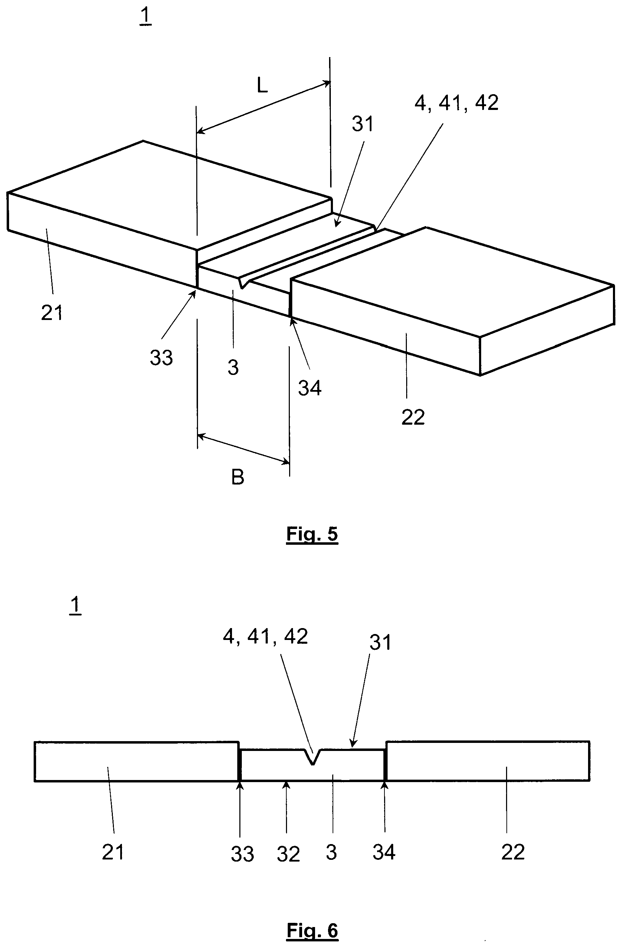

Fig. 5 zeigt eine Schrägansicht einer Widerstandsanordnung 1 mit einem weiteren alternativen Formelement 4. Fig. 6 zeigt eine Seitenansicht der Widerstandsanordnung gemäß Fig. 5. Das Widerstandselement 3 ist an seinen beiden Längsseiten 33, 34 jeweils mit einem Anschlusselement 21, 22 elektrisch leitend verbunden. Dadurch wird im Widerstandselement 3 eine Stromflussrichtung definiert, die senkrecht zu den beiden Längsseiten 33, 34, also längs zur Breitenrichtung, orientiert ist. Die Anschlusselemente 21, 22 können Verbindungsmittel zum Einbinden der Widerstandsanordnung 1 in einen äußeren Stromkreis aufweisen. Diese Verbindungsmittel sind aus Gründen der Übersichtlichkeit nicht dargestellt.

Auf seiner Oberseite 31 weist das Widerstandselement 3 ein Formelement 4 auf, das als Aussparung 41 im Material des Widerstandselements 3 gebildet ist. Die Aussparung 41 ist als V-förmige Nut 42 ausgeführt und mittig zwischen den beiden Längsseiten 33, 34 des Widerstandselements 3 angeordnet. Die Nut 42 erstreckt sich parallel zu den beiden Längsseiten 33, 34 über die gesamte Länge L des Widerstandselements 3. Die Nut 42 ist also in Stromflussrichtung räumlich begrenzt, nicht jedoch quer zur Stromflussrichtung. Durch ihre räumliche Begrenzung in Stromflussrichtung definiert die Nut 42 einen Bereich, der als Positionierhilfe für das Ende eines elektrischen Leiters dient. Der V-förmige Querschnitt ermöglicht die Zentrierung des Endes des elektrischen Leiters. Somit kann eine sehr genaue Positionierung des Messabgriffs erfolgen.

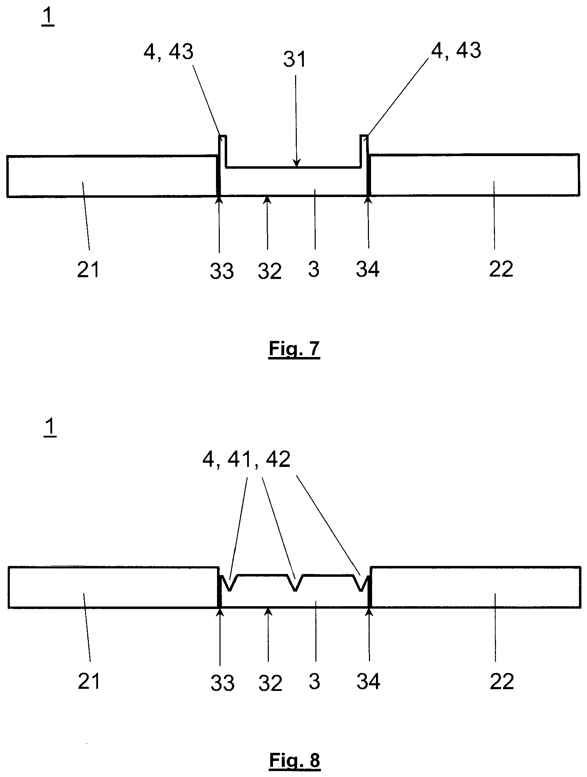

Fig. 7 zeigt eine Seitenansicht einer bevorzugten Ausführungsform einer Widerstandsanordnung 1. Das Widerstandselement 3 ist an seinen beiden Längsseiten 33, 34 jeweils mit einem Anschlusselement 21, 22 elektrisch leitend verbunden. Dadurch wird im Widerstandselement 3 eine Stromflussrichtung definiert, die senkrecht zu den beiden Längsseiten 33, 34, also längs zur Breitenrichtung, orientiert ist. Das Widerstandselement 3 weist auf seiner Oberfläche 31 zwei als Erhebung 43 ausgeführte Formelemente 4 auf, die jeweils nahe an einer der beiden Längsseiten 33, 34 des Widerstandselements 3 angeordnet sind. Die jeweilige Höhe der Erhebungen 43 ist so gewählt, dass die Erhebungen 43 jeweils einen Bereich aufweisen, der über die beiden Anschlusselemente 21, 22 hinausragt. Die Formelemente 4 sind jeweils als schmales Rechteckprofil ausgebildet und erstrecken sich parallel zu den beiden Längsseiten 33, 34 über die gesamte Länge des Widerstandselements 3. Die Erhebungen 43 sind also in Stromflussrichtung räumlich begrenzt, nicht jedoch quer zur Stromflussrichtung. Durch ihre räumliche Begrenzung in Stromflussrichtung definieren die Formelemente 4, 43 jeweils einen Bereich, der jeweils als Positionierhilfe für das Ende eines elektrischen Leiters dient. Somit kann die ausschließlich über dem Widerstandselement 3 abfallende Spannung erfasst werden, ohne dass dieses Spannungssignal von zusätzlichen Teilspannungen, die durch den Widerstand der Anschlusselemente 21, 22 verursacht sind, beeinflusst wird. Da sich der elektrische Widerstand des Widerstandselements 3 im Unterschied zum Widerstand der Anschlusselemente 21, 22 nicht mit der Temperatur verändert, ermöglicht die in Fig. 7 dargestellte Widerstandsanordnung eine sehr präzise Ermittlung der Stromstärke aus der gemessenen Spannung auch bei sich verändernder Temperatur. Die jeweils vom

Widerstandselement 3 abgewandte Fläche der Formelemente 4, 43 kann zumindest teilweise mit Lot beschichtet sein.

Fig. 8 zeigt eine Seitenansicht einer besonders bevorzugten Ausführungsform einer Widerstandsanordnung 1. Das Widerstandselement 3 weist auf seiner Oberfläche 31 drei Aussparungen 41 in Form von V-förmigem Nuten 42 auf. Die Nuten 42 erstrecken sich parallel zu den beiden Längsseiten 33, 34 jeweils über die gesamte Länge des Widerstandselements 3. Zwei der Nuten 42 sind jeweils nahe an einer der beiden Längsseiten 33, 34 des Widerstandselements 3 angeordnet. Die dritte Nut 42 ist mittig zwischen den beiden Längsseiten 33, 34 angeordnet. Die Nuten 42 dienen als Positionierhilfe für Messabgriffe. Mittels solcher Messabgriffe können bei der dargestellten Widerstandsanordnung 1 sowohl die über dem gesamten Widerstandselement 3 abfallende Spannung als auch die beiden Teilspannungen erfasst werden, die über jeweils einer Hälfte des Widerstandselements 3 abfallen. Durch Vergleich der aus den jeweiligen Spannungen ermittelten Stromstärke kann die Verlässlichkeit der Messungen beurteilt werden.

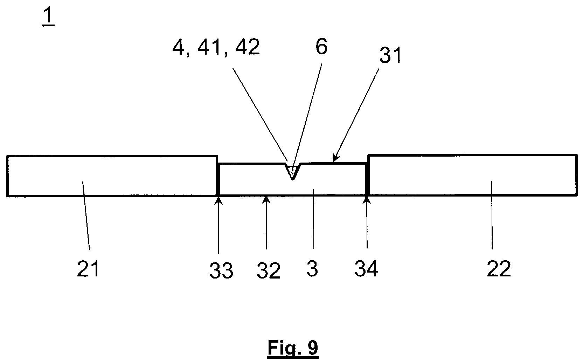

Fig. 9 zeigt eine Seitenansicht einer Widerstandsanordnung 1 mit einer Nut 42, die teilweise mit Lot 6 gefüllt ist. Es handelt sich um eine Weiterentwicklung der in Fig. 5 und Fig. 6 dargestellten Ausführungsform. Durch das in der Nut 42 vorhandene Lot 6 kann das Ende eines elektrischen Leiters ohne Zusatzaufwand mit dem Widerstandselement 3 verbunden werden.

Die in den dargestellten Ausführungsformen jeweils beschriebenen Merkmale können miteinander kombiniert und abgewandelt werden. Beispielsweise können auf einem Widerstandselement sowohl erhabene Formelemente als auch Formelemente, die als Aussparungen, insbesondere als Nuten ausgeführt sind, nebeneinander vorhanden sein.

### Bezugszeichenliste

- 1: Widerstandsanordnung
- 21: Anschlusselement
- 22: Anschlusselement
- 3: Widerstandselement
- 31: Oberseite
- 32: Unterseite
- 33: Längsseite
- 34: Längsseite
- 4: Formelement
- 41: Aussparung
- 42: Nut
- 43: Erhebung
- 6: Lot

- D: Dicke
- L: Länge
- B: Breite

## Patentansprüche

1. Widerstandsanordnung (1) umfassend mindestens zwei Anschlusselemente (21, 22) und mindestens ein zwischen den Anschlusselementen (21, 22) angeordnetes, streifen- oder plattenförmiges Widerstandselement (3),
wobei das Widerstandselement (3) eine Oberseite (31), eine Unterseite (32) und zwei parallel zueinander verlaufende Längsseiten (33, 34) aufweist, und
wobei das mindestens eine Widerstandselement (3) aus einem Material besteht, dessen elektrische Leitfähigkeit geringer ist als die elektrische Leitfähigkeit des Materials der Anschlusselemente (21, 22),
wobei das Widerstandselement (3) auf mindestens seiner Oberseite (31) oder mindestens seiner Unterseite (32) mindestens ein Formelement (4) als Positionierhilfe für das Anbringen eines elektrischen Leiters als Messabgriff aufweist,
**dadurch gekennzeichnet, dass** das mindestens eine Formelement (4) eine Aussparung (41) im Material des Widerstandselements (3) zur Aufnahme eines Endes eines elektrischen Leiters ist.

2. Widerstandsanordnung (1) nach Anspruch 1, **dadurch gekennzeichnet, dass** die Aussparung (41) eine Nut (42) ist, die sich parallel zu den Längsseiten (33, 34) des Widerstandselements (3) erstreckt.

3. Widerstandsanordnung (1) nach Anspruch 2, **dadurch gekennzeichnet, dass** die Nut (42) einen V-förmigen Querschnitt aufweist.

4. Widerstandsanordnung (1) nach einem der Ansprüche 1 bis 3, **dadurch gekennzeichnet, dass** die Aussparung (41) zumindest teilweise mit Lot (6) gefüllt ist.

5. Widerstandsanordnung (1) umfassend mindestens zwei Anschlusselemente (21, 22) und mindestens ein zwischen den Anschlusselementen (21, 22) angeordnetes, streifen- oder plattenförmiges Widerstandselement (3),
wobei das Widerstandselement (3) eine Oberseite (31), eine Unterseite (32) und zwei parallel zueinander verlaufende Längsseiten (33, 34) aufweist, und
wobei das mindestens eine Widerstandselement (3) aus einem Material besteht, dessen elektrische Leitfähigkeit geringer ist als die elektrische Leitfähigkeit des Materials der Anschlusselemente (21, 22),
wobei das Widerstandselement (3) auf mindestens seiner Oberseite (31) oder mindestens seiner Unterseite (32) mindestens ein Formelement (4) als Positionierhilfe für das Anbringen eines elektrischen Leiters als Messabgriff aufweist und wobei das mindestens eine Formelement (4) einen Bereich (43) aufweist, der über die Oberseite (31) oder über die Unterseite (32) des Widerstandselements (3) erhaben ist,
**dadurch gekennzeichnet, dass** das Material des erhabenen Bereichs (43) monolithisch mit dem Material des Widerstandselements (3) verbunden ist.

6. Widerstandsanordnung (1) nach Anspruch 5, **dadurch gekennzeichnet, dass** das Formelement (3) im erhabenen Bereich (43) zumindest teilweise mit Lot (6) beschichtet ist.

7. Widerstandsanordnung (1) nach einem der Ansprüche 1 bis 6, **dadurch gekennzeichnet, dass** das mindestens eine Formelement (4) mittig zwischen den Längsseiten (33, 34) des Widerstandselements (3) angeordnet ist.

8. Verfahren zur Herstellung einer Widerstandsanordnung (1) nach einem der vorstehenden Ansprüche, wobei das Verfahren folgende Schritte umfasst:
a) Bereitstellen eines ersten Bands aus einem ersten Material, wobei das Band eine Oberseite und eine Unterseite sowie zwei Längsseiten aufweist,
b) Festlegen der Breite B des ersten Bands,
c) Einbringen mindestens eines Formelements (4) in mindestens die Oberseite oder mindestens die Unterseite des ersten Bands,
d) Längsnahtschweißen des ersten Bands an seinen beiden Längsseiten mit jeweils einem weiteren Band aus einem Material, dessen elektrische Leitfähigkeit größer als die elektrische Leitfähigkeit des ersten Materials ist, wobei ein bandförmiger Werkstoffverbund gebildet wird,
e) Zertrennen des bandförmigen Werkstoffverbunds zur Herstellung einer Widerstandsanordnung (1), wobei aus dem Material des ersten Bands ein Widerstandselement (3) der Widerstandsanordnung (1) gebildet wird.

9. Verfahren zur Herstellung einer Widerstandsanordnung (1) nach einem der Ansprüche 1 bis 7, wobei das Verfahren folgende Schritte umfasst:
a) Bereitstellen eines ersten Bands aus einem ersten Material, wobei das Band eine Oberseite und eine Unterseite sowie zwei Längsseiten aufweist, und wobei das erste Band auf mindestens seiner Oberseite oder mindestens seiner Unterseite mindestens ein Formelement (4) aufweist,
b) Festlegen der Breite B des ersten Bands,
c) Längsnahtschweißen des ersten Bands an seinen beiden Längsseiten mit jeweils einem weiteren Band aus einem Material, dessen elektrische Leitfähigkeit größer als die elektrische Leitfähigkeit des ersten Materials ist, wobei ein bandförmiger Werkstoffverbund gebildet wird,
d) Zertrennen des bandförmigen Werkstoffverbunds zur Herstellung einer Widerstandsanordnung (1), wobei aus dem Material des ersten Bands ein Widerstandselement (3) der Widerstandsanordnung (1) gebildet wird.

## Claims

1. Resistor arrangement (1) comprising at least two connection elements (21, 22) and at least one strip-like or plate-like resistor element (3) which is arranged between the connection elements (21, 22),
wherein the resistor element (3) has an upper side (31), a lower side (32) and two longitudinal sides (33, 34) which extend parallel with each other, and
wherein the at least one resistor element (3) comprises a material whose electrical conductivity is lower than the electrical conductivity of the material of the connection elements (21, 22),
wherein the resistor element (3) has at least at the upper side (31) thereof or at least at the lower side (32) thereof at least one shaped element (4) as an auxiliary positioning member for fitting an electrical conductor as a measurement tapping location,
**characterised in that** the at least one shaped element (4) is a recess (41) in the material of the resistor element (3) for receiving one end of an electrical conductor.

2. Resistor arrangement (1) according to claim 1, **characterised in that** the recess (41) is a groove (42) which extends parallel with the longitudinal sides (33, 34) of the resistor element (3).

3. Resistor arrangement (1) according to claim 2, **characterised in that** the groove (42) has a V-shaped cross-section.

4. Resistor arrangement (1) according to any one of claims 1 to 3, **characterised in that** the recess (41) is at least partially filled with solder (6).

5. Resistor arrangement (1) comprising at least two connection elements (21, 22) and at least one strip-like or plate-like resistor element (3) which is arranged between the connection elements (21, 22),
wherein the resistor element (3) has an upper side (31), a lower side (32) and two longitudinal sides (33, 34) which extend parallel with each other, and
wherein the at least one resistor element (3) comprises a material whose electrical conductivity is lower than the electrical conductivity of the material of the connection elements (21, 22),
wherein the resistor element (3) has at least at the upper side (31) thereof or at least at the lower side (32) thereof at least one shaped element (4) as an auxiliary positioning member for fitting an electrical conductor as a measurement tapping location and wherein the at least one shaped element (4) has a region (43) which is raised above the upper side (31) or above the lower side (32) of the resistor element (3), **characterised in that** the material of the raised region (43) is connected in a monolithic manner to the material of the resistor element (3).

6. Resistor arrangement (1) according to claim 5, **characterised in that** the shaped element (3) is at least partially coated with solder (6) in the raised region (43).

7. Resistor arrangement (1) according to any one of claims 1 to 6, **characterised in that** the at least one shaped element (4) is arranged centrally between the longitudinal sides (33, 34) of the resistor element (3).

8. Method for producing a resistor arrangement (1) according to any one of the preceding claims, wherein the method comprises the following steps of:
a) providing a first strip made of a first material, wherein the strip has an upper side and a lower side and two longitudinal sides,
b) determining the width B of the first strip,
c) introducing at least one shaped element (4) into at least the upper side or at least the lower side of the first strip,
d) longitudinal seam welding of the first strip at both longitudinal sides thereof in each case to an additional strip made of a material whose electrical conductivity is greater than the electrical conductivity of the first material, wherein a strip-like material compound is formed,
e) separating the strip-like material compound in order to produce a resistor arrangement (1), wherein a resistor element (3) of the resistor arrangement (1) is formed from the material of the first strip.

9. Method for producing a resistor arrangement (1) according to any one of claims 1 to 7, wherein the method comprises the following steps of:
a) providing a first strip made of a first material, wherein the strip has an upper side and a lower side and two longitudinal sides and wherein the first strip has at least at the upper side thereof or at least at the lower side thereof at least one shaped element (4),
b) determining the width B of the first strip,
c) longitudinal seam welding of the first strip at both longitudinal sides thereof in each case to an additional strip made of a material whose electrical conductivity is greater than the electrical conductivity of the first material, wherein a strip-like material compound is formed,
d) separating the strip-like material compound in order to produce a resistor arrangement (1), wherein a resistor element (3) of the resistor arrangement (1) is formed from the material of the first strip.

## Revendications

1. Dispositif de résistance (1) comprenant au moins deux éléments de raccordement (21, 22) et au moins un élément de résistance (3) en forme de bande ou de plaque, agencé entre les éléments de raccordement (21, 22),
l'élément de résistance (3) présentant une face supérieure (31), une face inférieure (32) et deux côtés longitudinaux (33, 34) parallèles l'un à l'autre, et
l'au moins un élément de résistance (3) étant constitué d'un matériau dont la conductivité électrique est inférieure à la conductivité électrique du matériau des éléments de raccordement (21, 22),
l'élément de résistance (3) présentant, au moins sur sa face supérieure (31) ou au moins sur sa face inférieure (32), au moins un élément moulé (4) servant d'aide au positionnement pour la fixation d'un conducteur électrique comme prise de mesure,
**caractérisé en ce que** l'au moins un élément moulé (4) est un évidement (41) dans le matériau de l'élément de résistance (3) destiné à recevoir une extrémité d'un conducteur électrique.

2. Dispositif de résistance (1) selon la revendication 1, **caractérisé en ce que** l'évidement (41) est une rainure (42) qui s'étend parallèlement aux côtés longitudinaux (33, 34) de l'élément de résistance (3).

3. Dispositif de résistance (1) selon la revendication 2, **caractérisé en ce que** la rainure (42) présente une section transversale en forme de V.

4. Dispositif de résistance (1) selon l'une des revendications 1 à 3, **caractérisé en ce que** l'évidement (41) est au moins partiellement rempli de soudure (6).

5. Dispositif de résistance (1) comprenant au moins deux éléments de raccordement (21, 22) et au moins un élément de résistance (3) en forme de bande ou de plaque, agencé entre les éléments de raccordement (21, 22),
l'élément de résistance (3) présentant une face supérieure (31), une face inférieure (32) et deux côtés longitudinaux (33, 34) parallèles l'un à l'autre, et
l'au moins un élément de résistance (3) étant constitué d'un matériau dont la conductivité électrique est inférieure à la conductivité électrique du matériau des éléments de raccordement (21, 22), l'élément de résistance (3) présentant, au moins sur sa face supérieure (31) ou au moins sur sa face inférieure (32), au moins un élément moulé (4) servant d'aide au positionnement pour la fixation d'un conducteur électrique en tant que prise de mesure, et l'au moins un élément moulé (4) présentant une zone (43) qui est en relief par rapport à la face supérieure (31) ou à la face inférieure (32) de l'élément de résistance (3), **caractérisé en ce que** le matériau de la zone en relief (43) est relié de manière monolithique au matériau de l'élément de résistance (3).

6. Dispositif de résistance (1) selon la revendication 5, **caractérisé en ce que** l'élément moulé (3) est au moins partiellement recouvert de soudure (6) dans la zone en relief (43).

7. Dispositif de résistance (1) selon l'une des revendications 1 à 6, **caractérisé en ce que** l'au moins un élément moulé (4) est disposé au centre entre les côtés longitudinaux (33, 34) de l'élément de résistance (3).

8. Procédé de fabrication d'un dispositif de résistance (1) selon l'une des revendications précédentes, le procédé comprenant les étapes suivantes :
a) fourniture d'une première bande en un premier matériau, la bande présentant une face supérieure et une face inférieure ainsi que deux côtés longitudinaux,
b) détermination de la largeur B de la première bande,
c) introduction d'au moins un élément moulé (4) dans au moins la face supérieure ou au moins la face inférieure de la première bande,
d) soudage longitudinal de la première bande sur ses deux côtés longitudinaux avec respectivement une autre bande constituée d'un matériau dont la conductivité électrique est supérieure à la conductivité électrique du premier matériau, un composite de matériaux en forme de bande étant ainsi formé,
e) séparation du composite en forme de bande pour fabriquer un dispositif de résistance (1), un élément de résistance (3) du dispositif de résistance (1) étant formé à partir du matériau de la première bande.

9. Procédé de fabrication d'un dispositif de résistance (1) selon l'une des revendications 1 à 7, le procédé comprenant les étapes suivantes :
a) fourniture d'une première bande constituée d'un premier matériau, la bande présentant une face supérieure et une face inférieure ainsi que deux côtés longitudinaux et la première bande présentant au moins sur sa face supérieure ou au moins sur sa face inférieure au moins un élément moulé (4),
b) détermination de la largeur B de la première bande,
c) soudage longitudinal de la première bande sur ses deux côtés longitudinaux avec respectivement une autre bande constituée d'un matériau dont la conductivité électrique est supérieure à la conductivité électrique du premier matériau,
un composite en forme de bande étant formé,
d) découpage du composite en forme de bande pour fabriquer un dispositif de résistance (1), un élément de résistance (3) du dispositif de résistance (1) étant formé à partir du matériau de la première bande.
